(19) Europäisches Patentamt / European Patent Office / Office européen des brevets

(11) **EP 4 415 238 A1**

(12) **DEMANDE DE BREVET EUROPEEN**

(43) Date de publication:
**14.08.2024   Bulletin 2024/33**

(21) Numéro de dépôt: **24157092.8**

(22) Date de dépôt: **12.02.2024**

(51) Classification Internationale des Brevets (IPC):
**H02M 1/00** *(2006.01)*     **H02M 3/07** *(2006.01)*
**H02M 3/156** *(2006.01)*     **H02M 3/335** *(2006.01)*
**H02M 7/48** *(2007.01)*

(52) Classification Coopérative des Brevets (CPC):
**H02M 1/007; H02M 3/156; H02M 3/335;**
H02M 3/07; H02M 7/4826

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**GE KH MA MD TN**

(30) Priorité:   **13.02.2023   FR 2301312**

(71) Demandeur: **SCHNEIDER ELECTRIC INDUSTRIES SAS**
**92500 Rueil-Malmaison (FR)**

(72) Inventeur: **SICARD, Stéphane**
**38350 LA MURE (FR)**

(74) Mandataire: **Lavoix**
**62, rue de Bonnel**
**69448 Lyon Cedex 03 (FR)**

(54)   **MODULE DE FOURNITURE D'ÉNERGIE ÉLECTRIQUE**

(57)   L'invention concerne un module (2) de fourniture d'énergie électrique configuré pour convertir une énergie électrique alternative en énergie électrique continue pour alimenter une charge résistive, comportant un bloc de transformation du courant (4) comportant un transformateur magnétique de courant (15) ayant une inductance magnétisante équivalente, un bloc (6) de conversion de tension alternative en tension continue, un bloc (10) de stockage d'énergie, et un bloc (12) de régulation de tension de sortie adapté à fournir une énergie électrique à la charge résistive (14). Le bloc (6) de conversion de tension alternative en tension continue comporte un condensateur de compensation (22) configuré pour compenser une perte d'énergie due au transformateur magnétique de courant, le bloc (6) de conversion de tension alternative en tension continue étant connecté entre le bloc de transformation de courant (4) et le bloc de stockage d'énergie (10).

FIG.2

EP 4 415 238 A1

**Description**

La présente invention concerne un module de fourniture d'énergie électrique, configuré pour convertir une énergie électrique alternative en énergie électrique continue pour alimenter une charge résistive.

L'invention se site dans le domaine de l'alimentation électrique de charges.

Plus particulièrement, l'invention se situe dans le domaine de l'alimentation en énergie électrique par récupération d'énergie électrique d'un champ magnétique formé autour d'un conducteur traversé par un courant électrique.

L'utilisation d'un transformateur de courant et d'un redresseur de courant, configuré pour obtenir une énergie électrique continue à partir d'une énergie électrique alternative (ou AC/DC) est connue, mais de tels transformateurs de courant classiques présentent un encombrement qui n'est pas compatible avec certaines applications.

Un objectif de l'invention est de proposer un module de fourniture d'énergie électrique, destiné à alimenter en tension/courant électrique un dispositif électronique (e.g. une carte électronique) intégrée dans un dispositif de mesure de grandeurs électriques. Ainsi, ce dispositif de mesure est autonome en termes d'alimentation électrique.

Dans ce contexte, il existe un besoin de fournir un module de fourniture d'énergie électrique capable de fournir un courant électrique minimum de quelques centaines de micro-ampères($\mu$A), au démarrage, tout en respectant des contraintes de dimension.

A cet effet, l'invention propose, selon un aspect, un module de fourniture d'énergie électrique configuré pour convertir une énergie électrique alternative en énergie électrique continue pour alimenter une charge résistive, comportant un bloc de transformation du courant comportant un transformateur magnétique de courant ayant une inductance magnétisante équivalente, un bloc de conversion de tension alternative en tension continue, un bloc de stockage d'énergie, et un bloc de régulation de tension de sortie adapté à fournir une énergie électrique à la charge résistive. Le bloc de conversion de tension alternative en tension continue comporte un condensateur de compensation configuré pour compenser une perte d'énergie due au transformateur magnétique de courant, le bloc de conversion de tension alternative en tension continue étant connecté entre le bloc de transformation de courant et le bloc de stockage d'énergie.

Avantageusement, le module de fourniture d'énergie électrique proposé est compact, grâce au condensateur de compensation configuré pour compenser une perte d'énergie due à l'inductance magnétisante équivalente du transformateur magnétique de courant. En effet, le condensateur de compensation crée un effet résonant avec le bloc de transformation de courant, ce qui permet d'optimiser la collecte d'énergie, et par conséquent, de diminuer la taille des composants du bloc de transformation de courant à utiliser pour une même énergie électrique fournie.

Le module de fourniture d'énergie électrique selon l'invention peut présenter une ou plusieurs des caractéristiques ci-dessous, prises indépendamment ou selon toutes les combinaisons acceptables.

Le bloc de conversion de tension alternative en tension continue est un bloc multiplicateur de tension comportant ledit condensateur de compensation, une première diode anti-retour connectée en sortie du condensateur de compensation, configurée pour empêcher un retour de courant électrique vers ledit condensateur de compensation, et une deuxième diode anti-retour, connectée entre un point de connexion situé entre le condensateur de compensation et la première diode anti-retour, et un point de masse, la deuxième diode anti-retour étant configurée pour empêcher un passage de courant entre ledit point de connexion et la masse.

Le bloc de conversion de tension alternative en tension continue comporte en outre un condensateur, connecté entre le point de masse et la sortie de la première diode anti-retour.

Le condensateur de compensation a une capacité choisie en fonction d'une inductance magnétisante équivalente du transformateur magnétique de courant.

La capacité du condensateur de condensation est calculée par la formule suivante :

$$C_1 = \frac{1}{L_1 \times \omega_0^2}$$

dans laquelle C1 est la capacité du condensateur de compensation, L1 l'inductance magnétisante équivalente du transformateur magnétique de courant et $\omega_0$ la pulsation du courant électrique alternatif en sortie du bloc de transformation de courant.

Le bloc de stockage d'énergie comporte un condensateur de stockage, connecté entre un point de sortie du bloc de conversion et un point de masse.

Le module comporte en outre un bloc d'adaptation d'impédance, connecté entre le bloc de conversion de tension alternative en tension continue et le bloc de stockage d'énergie, le bloc d'adaptation d'impédance réalisant une égalisation entre une impédance de charge et une impédance de source, ledit bloc de stockage d'énergie comportant un condensateur de stockage, connecté entre un point de sortie du bloc d'adaptation d'impédance et un point de masse.

Le bloc d'adaptation d'impédance comporte un composant inductif, connecté en sortie du bloc de conversion de tension, une diode connectée en sortie du composant inductif et un transistor, connecté entre un point de connexion situé entre la sortie dudit composant inductif et l'entrée de ladite diode, le transistor étant commandé par un signal de commande fonction d'une comparaison de tension entre une tension de consigne et une tension de sortie du module de fourniture d'énergie électrique.

Le bloc de conversion de tension, le bloc d'adaptation d'impédance, le bloc de stockage d'énergie et le bloc de régulation de tension sont réalisés par une unité électronique de traitement.

D'autres caractéristiques et avantages de l'invention ressortiront de la description qui en est donnée ci-dessous, à titre indicatif et nullement limitatif, en référence aux figures annexées, parmi lesquelles :

[Fig 1] la figure 1 est une représentation des principaux blocs d'un module de fourniture d'énergie électrique selon un mode de réalisation ;
[Fig 2] la figure 2 est un exemple de mise en oeuvre des blocs d'un module de fourniture d'énergie électrique selon un premier mode de réalisation ;
[Fig 3] la figure 3 est un modèle électrique équivalent du transformateur magnétique de courant de la figure 2 ;
[Fig 4] la figure 4 est un graphe de courbes illustrant les performances de fourniture d'énergie électrique.

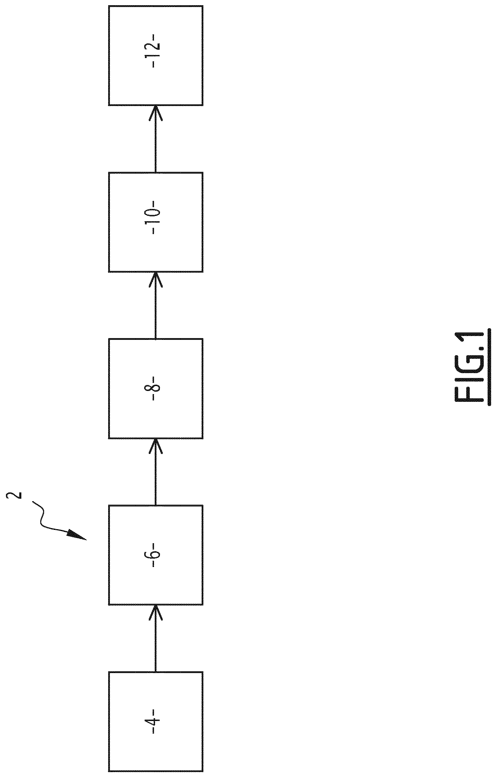

La figure 1 illustre les principaux blocs d'un module de fourniture d'énergie électrique 2.

Le module 2 de fourniture d'énergie électrique est configuré pour collecter de l'énergie électrique à partir du champ magnétique créé par un conducteur électrique.

Plus généralement, le module 2 est configuré pour fournir une énergie électrique à partir d'une source d'énergie électrique alternative pour la transformer en énergie électrique continue, et alimenter une charge résistive 14, e.g. une carte électronique configurée pour effectuer des calculs, par exemple pour calculer des valeurs caractéristiques de grandeurs électriques dans une installation électrique. Notamment une tension continue est fournie en sortie du module 2 de fourniture d'énergie électrique pour alimenter la charge.

Le module 2 de fourniture d'énergie électrique comprend un bloc de transformation de courant 4 comportant un transformateur de courant.

De manière connue, un transformateur magnétique de courant comporte des enroulements (ou bobines électriques) primaire et secondaire, les courants électriques traversant ces enroulements étant respectivement appelés courant primaire et courant secondaire. Le courant secondaire est pratiquement proportionnel au courant primaire et déphasé de celui-ci d'un angle voisin de zéro pour un sens approprié des connexions.

Un tel transformateur magnétique de courant est représenté par un modèle électrique équivalent comportant une source de courant et un composant inductif, appelé composant inductif magnétisant équivalent, connecté en parallèle de la source de courant. L'inductance du composant inductif est appelée par la suite inductance magnétisante équivalente du transformateur magnétique de courant.

En sortie du bloc de transformation de courant 4 est connecté un bloc 6 de conversion d'une énergie électrique alternative en énergie électrique continue (conversion AC/DC), notamment configuré pour transformer une tension alternative en tension continue.

Par la suite, le bloc 6 sera appelé bloc de conversion de tension ou bloc de conversion AC/DC.

Avantageusement, ce bloc 6 de conversion de tension comporte notamment un circuit capacitif qui est configuré pour compenser les pertes d'énergie du composant inductif magnétisant équivalent du bloc 4 de transformation de courant.

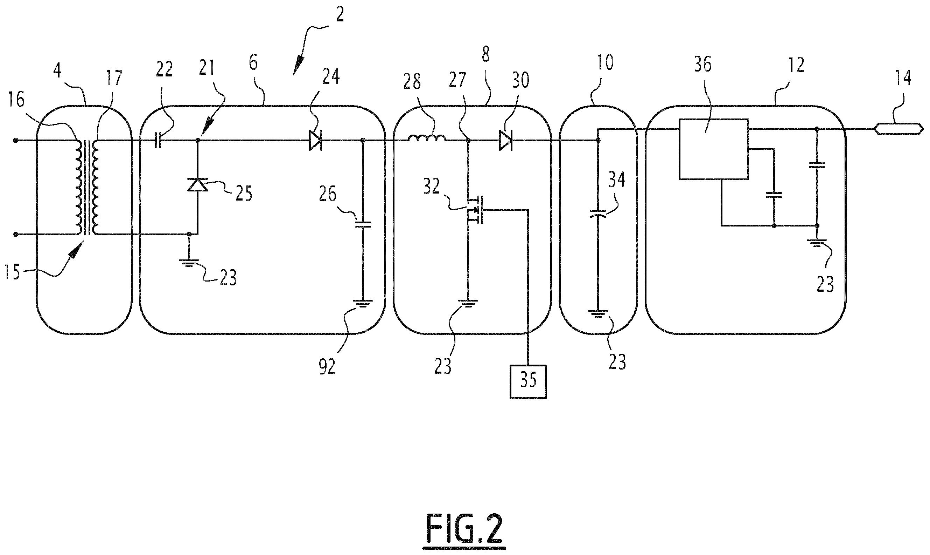

Dans un mode réalisation, le bloc 6 de conversion de tension est un multiplicateur de tension, de préférence un doubleur de tension de type circuit de Greinacher, et plus généralement un multiplicateur de tension, comme expliqué plus en détail ci-après en référence à la figure 2.

Le module 2 comporte en outre, en sortie du bloc 6 de conversion de tension, un bloc d'adaptation d'impédance 8, dont la sortie est connectée en entrée d'un bloc de stockage d'énergie électrique 10.

Le bloc d'adaptation d'impédance 8 réalise une égalisation entre une impédance de charge et une impédance de source.

Le bloc d'adaptation d'impédance 8 est optionnel, des modes de réalisation sans un tel bloc d'adaptation d'impédance 8 sont envisageables.

Le module 2 de fourniture d'énergie électrique comporte en outre un bloc 12 de régulation de tension, adapté pour réguler la tension continue en sortie du module 2 aux besoins en consommation électrique de la charge 14.

Un mode de réalisation de circuits électriques permettant de réaliser chacun des blocs décrits fonctionnellement ci-dessus est illustré dans la figure 2.

Dans ce mode de réalisation, le bloc de transformation de courant 4 comporte un transformateur magnétique de courant 15 comportant un enroulement primaire 16 et un enroulement secondaire 17.

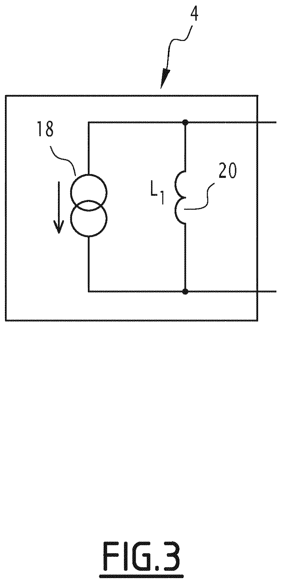

La figure 3 illustre un modèle électrique équivalent du transformateur magnétique de courant 4, sous forme d'une source de courant 18 et d'un composant inductif magnétisant équivalent 20, d'inductance magnétisante équivalente notée L1.

Dans le mode de réalisation de la figure 2, le bloc 6 de conversion AC/DC est un circuit doubleur de tension de Greinacher.

Ce bloc 6 de conversion AC/DC comporte un circuit capacitif, dans ce mode de réalisation un condensateur dit de compensation 22, ayant une valeur de capacité C1, et une première diode anti-retour 24 connectée en sortie du condensateur de compensation 22.

Le première diode anti-retour 24 est configurée pour empêcher un retour de courant électrique vers le condensateur de compensation 22.

De plus, le bloc 6 de conversion AC/DC comporte une deuxième diode anti-retour 25, connectée entre un point de connexion 21 et un point 23 de potentiel bas, par exemple connecté à la masse. Le point de connexion 21 forme un noeud de connexion, entre la sortie du condensateur 22 et l'entrée de la première diode anti-retour 24, et la sortie de la deuxième diode anti-retour 25.

La deuxième diode anti-retour 25 est configurée pour empêcher un passage de courant entre le point de connexion 21 et la masse 23.

De préférence, le condensateur de compensation 22 a une capacité choisie en fonction de l'inductance L1, égale à l'inductance magnétisante équivalente du transformateur magnétique du bloc de transformation de courant 4, de manière à obtenir une résonance et compenser une perte d'énergie due au transformateur de courant.

Dans un mode de réalisation la capacité C1 est calculée en fonction de l'inductance L1 par la formule suivante :

[MATH 1]

$$C_1 = \frac{1}{L_1 \times \omega_0^2}$$

Où $\omega_0$ est la pulsation du courant électrique alternatif en sortie du bloc de transformation de courant, où $\omega_0 = 2\pi f_0$, $f_0$ étant la fréquence du signal.

De plus, le bloc 6 de conversion AC/DC comporte en outre un autre condensateur 26, connecté entre la masse 23 et la sortie de la diode anti-retour 24. Le condensateur 26 permet un stockage d'énergie de réserve, pour le circuit de Greinacher mais également pour la charge.

Par exemple, dans un mode de réalisation, le condensateur 26 a une capacité de $10\mu P$.

Le bloc d'adaptation d'impédance 8 est un convertisseur de type « Boost DC-DC » dans ce mode de réalisation. Ce bloc d'adaptation d'impédance 8 comporte un composant inductif 28 connecté en sortie du bloc 6 de conversion de tension, une diode 30 connectée en sortie du composant inductif 28 et un transistor 32, connecté entre point de connexion 27 situé entre la sortie de l'inductance 28 et l'entrée de la diode 30, commandé par un signal de commande 35 en fonction de la tension fournie en sortie du module 2. Le transistor 32 a une fonction d'interrupteur, le signal de commande étant fonction d'une comparaison de tension entre une tension de consigne et une tension de sortie du module 2 de fourniture d'énergie électrique.

En variante, le bloc d'adaptation d'impédance est réalisé par d'autres types de convertisseur, par exemple un convertisseur « Buck-Boost DC-DC converter », ou un convertisseur de type « Buck DC-DC converter ».

Le transistor 32 est par exemple un transistor MOSFET.

Le bloc de stockage d'énergie 10 comporte un condensateur de stockage 34 connecté entre la sortie du bloc d'adaptation d'impédance 8 et la masse 23.

Par exemple, le condensateur de stockage 34 a une capacité de $330\mu F$.

Le bloc 12 de régulation de tension comporte un régulateur de tension linéaire ou un régulateur à découpage.

Avantageusement, l'utilisation d'un bloc de conversion de tension comportant un condensateur de compensation permet de compenser les pertes induites par le composant inductif magnétisant du bloc de transformation de courant.

Avantageusement, l'ajout en outre d'un bloc d'adaptation d'impédance permet d'optimiser la fourniture d'énergie électrique par le module 2 de fourniture d'énergie électrique 2, tout en permettant de réduire l'encombrement de ce module 2.

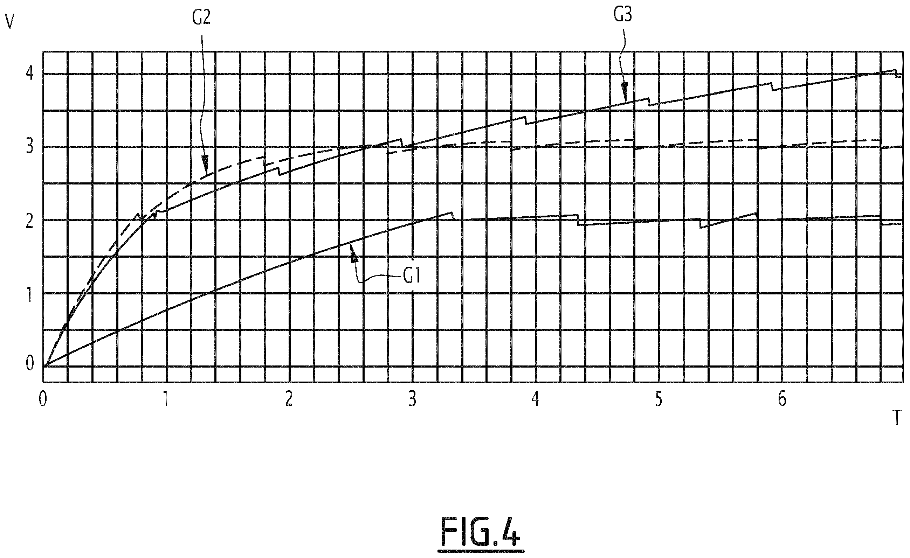

La figure 4 illustre la performance obtenue, et plus précisément la tension fournie en sortie d'un module 2 de fourniture d'énergie électrique par rapport à un module de fourniture d'énergie électrique dépourvu respectivement d'un bloc de conversion de tension alternative en tension continue, comportant un circuit capacitif comportant un condensateur de compensation d'inductance ou d'un bloc d'adaptation d'impédance.

La figure 4 représente un graphe, l'axe des abscisses représentant le temps et l'axe des ordonnées la tension aux bornes du condensateur de stockage 34

La courbe G1 représente la tension obtenue sans mettre en oeuvre la résonance du bloc 6 de conversion de tension incluant le condensateur de compensation d'inductance 22 , et sans bloc d'adaptation d'impédance 8. Une tension continue d'environ 2V est obtenue après le temps de charge du condensateur de stockage 34.

La courbe G2 représente la tension obtenue lorsque la valeur du condensateur de compensation du module 2 est accordée avec la valeur de l'inductance magnétisante équivalente du transformateur magnétique de courant, (ou en d'autres termes, avec résonnance), sans bloc d'adaptation d'impédance ; la courbe G3 représente la tension obtenue lorsque le module 2 de fourniture d'énergie électrique comprend un bloc de conversion de tension 6 avec condensateur de compensation de l'inductance magnétisante équivalente (en d'autres termes, avec résonance) et avec un bloc 8 d'adaptation d'impédance.

Comme illustré à la figure 4, à bloc de transformation de courant 4 identique, la tension fournie par le module 2 de fourniture d'énergie électrique est bien plus élevée lorsque le bloc de conversion de tension 6 avec résonance, puis d'adaptation d'impédance 8 sont utilisés.

Dans la description ci-dessus, le bloc de conversion de tension alternative en tension continue est réalisé par un multiplicateur de tension de Greinacher.

En variante, d'autres types de convertisseur AC/DC comportant un condensateur de compensation d'inductance peuvent être mis en oeuvre. Avantageusement, le module de fourniture d'énergie électrique décrit peut être intégré dans un dispositif de mesure de grandeurs électriques, de type fermé ou de type ouvrant.

Par exemple, le bloc 4 de transformation de courant est réalisé sous forme de capteur comportant un logement traversant adapté pour recevoir un conducteur électrique, de type fermé ou de type ouvrant, et les blocs 6 de conversion de tension, 8 d'adaptation d'impédance, 10 de stockage d'énergie et 12 de régulation de tension sont réalisés par une unité électronique de traitement, par exemple sous forme de circuits intégrés sur une carte électronique.

**Revendications**

1. Module de fourniture d'énergie électrique configuré pour convertir une énergie électrique alternative en énergie électrique continue pour alimenter une charge résistive, comportant un bloc de transformation du courant (4) comportant un transformateur magnétique de courant ayant une inductance magnétisante équivalente, un bloc (6) de conversion de tension alternative en tension continue, ledit bloc (6) étant un multiplicateur de tension de Greinacher, un bloc (10) de stockage d'énergie, et un bloc (12) de régulation de tension de sortie adapté à fournir une énergie électrique à la charge résistive (14), **caractérisé en ce que** le bloc (6) de conversion de tension alternative en tension continue comporte un condensateur de compensation (22) configuré pour compenser une perte d'énergie due au transformateur magnétique de courant, le bloc (6) de conversion de tension alternative en tension continue étant connecté entre le bloc de transformation de courant (4) et le bloc de stockage d'énergie (10).

2. Module selon la revendication 1, dans lequel le bloc (6) de conversion de tension alternative en tension continue est un bloc multiplicateur de tension comportant ledit condensateur de compensation (22), une première diode anti-retour (24) connectée en sortie du condensateur de compensation (22), configurée pour empêcher un retour de courant électrique vers ledit condensateur de compensation (22), et une deuxième diode anti-retour (25), connectée entre un point de connexion (21) situé entre le condensateur de compensation (22) et la première diode anti-retour (24), et un point de masse (23), la deuxième diode anti-retour (25) étant configurée pour empêcher un passage de courant entre ledit point de connexion (21) et la masse.

3. Module selon la revendication 1 ou 2, dans lequel le condensateur de compensation (22) a une capacité choisie en fonction d'une inductance magnétisante équivalente du transformateur magnétique de courant.

4. Module selon la revendication 3, dans lequel la capacité du condensateur de condensation est calculée par la formule suivante :

$$C_1 = \frac{1}{L_1 \times \omega_0^2}$$

dans laquelle C1 est la capacité du condensateur de compensation, L1 l'inductance magnétisante équivalente du transformateur magnétique de courant et $\omega_0$ la pulsation du courant électrique alternatif en sortie du bloc de transformation de courant.

5. Module selon l'une quelconque des revendications 1 à 4, dans lequel ledit bloc (10) de stockage d'énergie comporte un condensateur de stockage (34), connecté entre un point de sortie du bloc de conversion et un point de masse (23).

6. Module selon l'une quelconque des revendications 1 à 4, comportant en outre un bloc d'adaptation d'impédance (8), connecté entre le bloc de conversion (6) de tension alternative en tension continue et le bloc de stockage d'énergie (10), le bloc d'adaptation d'impédance (8) réalisant une égalisation entre une impédance de charge et une impédance de source, ledit bloc de stockage d'énergie (10) comportant un condensateur de stockage (34), connecté entre un point de sortie du bloc d'adaptation d'impédance (8) et un point de masse (23).

7. Module selon la revendication 6, dans lequel ledit bloc d'adaptation d'impédance (8) comporte un composant inductif (28), connecté en sortie du bloc (6) de conversion de tension, une diode (30) connectée en sortie du composant inductif (28) et un transistor (32), connecté entre un point de connexion (27) situé entre la sortie dudit composant inductif (28) et l'entrée de ladite diode (30), le transistor (32) étant commandé par un signal de commande fonction d'une comparaison de tension entre une tension de consigne et une tension de sortie du module de fourniture d'énergie électrique (2).

8. Module selon l'une quelconque des revendications 6 ou 7, dans lequel le bloc (6) de conversion de tension, le bloc (8) d'adaptation d'impédance, le bloc (10) de stockage d'énergie et le bloc (12) de régulation de tension sont réalisés par une unité électronique de traitement.

2

```
┌───────┐     ┌───────┐     ┌───────┐     ┌───────┐     ┌───────┐
│  -4-  │ ──▶ │  -6-  │ ──▶ │  -8-  │ ──▶ │ -10-  │ ──▶ │ -12-  │
└───────┘     └───────┘     └───────┘     └───────┘     └───────┘
```

## FIG.1

FIG.2

EP 4 415 238 A1

4

18

20

$L_1$

FIG.3

EP 4 415 238 A1

FIG.4

Europäisches Patentamt

European Patent Office

Office européen des brevets

# RAPPORT DE RECHERCHE EUROPEENNE

Numéro de la demande

EP 24 15 7092

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2021/376662 A1 (ARTEAGA JUAN [GB] ET AL) 2 décembre 2021 (2021-12-02) * alinéas [0054] – [0062]; figure 3 * ----- | 1-8 | INV. H02M1/00 H02M3/07 H02M3/156 H02M3/335 H02M7/48 |

DOMAINES TECHNIQUES RECHERCHES (IPC)

H02M

Le présent rapport a été établi pour toutes les revendications

| Lieu de la recherche | Date d'achèvement de la recherche | Examinateur |
|---|---|---|
| La Haye | 19 février 2024 | Zeljkovic, Sandra |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 24 15 7092

La présente annexe indique les membres de la famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

19-02-2024

| Document brevet cité au rapport de recherche | Date de publication | Membre(s) de la famille de brevet(s) | Date de publication |
|---|---|---|---|
| US 2021376662 A1 | 02-12-2021 | US 2021376662 A1 | 02-12-2021 |
| | | WO 2020008198 A1 | 09-01-2020 |

EPO FORM P0460

Pour tout renseignement concernant cette annexe : voir Journal Officiel de l'Office européen des brevets, No.12/82